# EUROPÄISCHE PATENTANMELDUNG

(11) **EP 0 899 821 A2**
(43) Veröffentlichungstag der Anmeldung: **03.03.1999**
(21) Anmeldenummer: 98115867.8
(22) Anmeldetag: 22.08.1998
(51) Int. Cl.: H01R 13/03

(54) **Bedieneinheit**

(30) Priorität: 29.08.1997 DE 19737698; 29.08.1997 DE 19737730; 29.08.1997 DE 19737692; 30.07.1998 DE 19834348
(71) Anmelder: GRUNDIG Aktiengesellschaft, 90762 Fürth (DE)
(72) Erfinder: Sölkner, Thomas, 90762 Fuerth (DE); Lorenz, Werner, 90762 Fuerth (DE); Ferger, Manfred, 90762 Fuerth (DE); Höbel, Peter, 90762 Fuerth (DE); Weidel, Günther, 90762 Fuerth (DE)

(57) **Zusammenfassung**

Die Erfindung betrifft eine Bedeineinheit, einen elektrischen Steckerverbinder, einen elektrischen Taster, eine elekrtische Anschlußbuchseund ein Verfahren zur Metallisierung von Kunststoffoberflächen.
Der elektrische Steckverbinder besteht aus 2 Verbindungselementen, wobei ein erstes Verbindungselement ein Trägerstück mit mindestens einem Kontaktelement aufweist. Zur Vereinfachung der Herstellung und zur Erleichterung der Wiederverwertung der eingesetzten Rohstoffe ist erfindungsgemäß vorgesehen, daß das Trägerstück und das Kontaktelement aus einem ersten thermoplastischen Kunststoff hergestellt sind, dessen Oberfläche zumindest abschnittsweise chemisch metallisierbar ist.

## Beschreibung

Die Erfindung betrifft eine Bedieneinheit nach dem Oberbegriff des Anspruchs 1, einem elektrischen Taster nach dem Oberbegriff des Anspruches 12, einem elektrischen Steckerverbinder nach dem Oberbegriff des Anspruches 2, einer elektrischen Anschlußbuchse nach dem Oberbegriff des Anspruches 22 und einem Verfahren zur Metallisierung einer Kunststoffoberfläche nach Anspruch 33.

Eine derartige Bedieneinheit wird beispielsweise in der Unterhaltungselektronik verwendet. Zumeist besteht eine derarige Bedieneinheit aus mehreren Einzelkomponenten. Die Komponenten werden in einem oder mehrerern Arbeitsgängen zur Bedieneinheit zusammengesetzt.

Bei den Komponenten handelt es sich, unter anderem um eine Leiterplatte, einen elektrischen Taster, einen elektrischen Steckerverbinder und eine elektrischen Anschlußbuchse.

Ein solcher elektrischer Taster wird z.B. bei Fernseh- oder Videogeräten verwendet. Dabei handelt es sich um ein gesondertes Bauelement, welches auf einer herkömmlich strukturierten FR 2- oder FR 4-Leiterplatte durch Verlöten montiert ist. Die derart bestückte Leiterplatte ist im Gerät üblicherweise hinter einer Bedienblende angeordnet, welche Bedienelemente zur Übertragung einer Tastbewegung auf den Taster aufweisen.

Die bekannte Technik ist in mehrfacher Hinsicht nachteilig:
a) Taster und Leiterplatte müssen gesondert gefertigt und vorgehalten werden.
b) Die Leiterplatte muß unter hohem apparativem Aufwand oder per Hand mit dem Taster bestückt werden.
c) Der Taster muß auf der Leiterplatte montiert werden.
d) Ein Recycling der Leiterplatte erfordert eine Demontage des Tasters.
e) Herkömmliche Taster sind schwer recycelbar.

Solche Steckerverbinder bestehen aus zwei Verbindungselementen, welche zur Herstellung einer elektrischen Verbindung ineinander steckbar sind. Sie werden nach dem Stand der Technik z.B. zur Verbindung von Leiterplatten verwendet. Sie bestehen aus metallischen Kontaktelementen, die von einem elektrisch isolierenden Kunststoffspritzgußteil umgeben sind. Die Kontaktelemente des "Steckers" bestehen dabei meist aus Metallstiften, die der "Steckdose" aus Metallfedern.

Die Steckerverbinder nach dem Stand der Technik sind in mehrfacher Hinsicht nachteilig:
a) Die Kontaktelemente müssen gesondert gefertigt und vorgehalten werden.
b) Der apparative Aufwand zum Umspritzen der Metallstifte des "Steckers" bzw. zum Einpressen von Metallfedern in ein dei "Steckdose" bildendes Kunststoffspritzgußteil ist hoch.
c) Das Bestücken und die Montage von Verbindungselementen auf Leiterplatten erfordert einen hohen apparativen Aufwand oder muß per Hand erfolgen.
d) Das Recycling von Leiterplatten erfordert eine vorherige Demontage von Verbindungselementen.
e) Steckerverbinder sind schwer recycelbar.

Eine solche Anschlußbuchse, die auch als Cinch-Buchse bekannt ist, wird z.B. bei Fernseh- oder Videogeräten verwendet. Dabei handelt es sich um ein gesondertes Bauelement, bei dem ein erstes zylindrisches metallisches Kontaktelement von einem zweiten zylindrischen metallischen Kontaktelement in koaxialer Anordnung umgeben ist. Zwischen den beiden Kontaktelementen ist ein elektrisch isolierender Kunststoffrohrabschnitt vorgesehen, der Bestandteil eines Trägerstücks ist. Herkömmliche Anschlußbuchsen müssen auf Leiterplatten bestückt und durch Verlöten montiert werden.
Die nach dem Stand der Technik bekannten Anschlußbuchsen sind in mehrfacher Hinsicht nachteilig:
a) Die Kontaktelemente der Anschlußbuchse müssen gesondert gefertigt und vorgehalten werden.
b) Der zur Montage der Kontaktelemente auf das Trägerstück erforderliche apparative Aufwand ist hoch.
c) Das Bestücken und die Montage der Anschlußbuchse auf die Leiterplatte erfordert einen hohen apparativen Aufwand oder muß per Hand erfolgen.
d) Ein Recycling von mit Anschlußbuchsen versehenen Leiterplatten (Baugruppen) erfordert deren vorherige Demontage.
e) Anschlußbuchsen sind als solche schwer recyclebar.

Nach dem Stand der Technik werden Kunststoffoberflächen vor dem galvanischen Aufbringen einer Metallschicht geätzt und nachfolgend mit Metallkeimen belegt.
Beim Ätzen wird eine oberflächliche Mikrorauhigkeit erzeugt. Das Ätzen erfolgt üblicherweise durch Tauchen der Oberfläche in Chrom(VI)Oxid-Schwefelsäure oder durch Plasmabehandlung. - Chrom(VI)Oxid-Schwefelsäure ist giftig und aggressiv. Ihre Handhabung und Entsorgung ist aufwendig und teuer. Auch das Ätzen mittels Plasmabehandlung ist aufwendig und teuer.

Aufgabe der vorliegenden Erfindung ist es, eine Bedieneinheit, einen elektrischen Steckerverbinder, bzw. ein Verbindungselement, einen elektrischen Taster, eine elektrische Anschlußbuchse und ein Verfahren zur Metallisierung einer Kunststoffoberfläche anzugeben, mit dem die Nachteile des Stands der Technik vermeidbar sind.

Es soll eine Bedieneinheit bereitgestellt werden, welche aus verschiedenen Komponenten besteht, welche einfach und kostengünstig herstellbar und ohne großen Aufwand recycelbar sind.
Es soll insbesondere ein elektrischer Steckerverbinder, ein elektrischer Schalter und eine elektrische Anschlußbuschse bereitgestellt werden, welche einfach und kostengünstig herstell- und ohne großen Aufwand recycelbar sind.
Im weiteren soll insbesondere ein möglichst einfach und kostengünstig durchführbares Verfahren zur Metallisierung einer Kunststoffoberfläche angegeben werden, welches möglichst umweltverträglich ist.

Diese Aufgabe wird durch die Merkmale der Ansprüche 1, 2, 12, 22 und 33 gelöst.
Zweckmäßige Ausgestaltungen ergeben sich aus den Merkmalen der abhängigen Ansprüche.

### Bedieneinheit

Die Bedeineinheit wird in zwei Arbeitsvorgängen hergestellt. Zunächst wird ein sogenannter erster Spritzling aus thermoplatischem Kunststoff hergestellt. Dieser erste Spritzling weist beispielsweise bereits die Konturen für Leiterbahnen, Tasten, Anschlußbuchsen, Kontaktpunkte und Steckerverbinder auf.
Anschließend wird der erste Spritzling vorbehandelt, damit der thermoplastische Kunststoff metallisierbar ist. Danach wird der erste Spritzling mit weiterem thermoplastischem Kunststoff unspritzt, wobei diejenigen Stellen frei bleiben, welche anschließend metallisiert werden. Auf diese Weise werden Durchkontaktierungen durch die Bedieneinheit, Leiterbahnen, Taster, Anschlußbuchsen, Steckerverbinder und weitere Elemente direkt auf der Bedieneinheit erzeugt.

### Elektrischer Steckverbinder

Nach Maßgabe der Erfindung ist vorgesehen, daß das Trägerstück und das Kontaktelement aus einem ersten thermoplastischen Kunststoff hergestellt sind, dessen Oberfläche zumindest abschnittsweise chemisch metallisierbar ist. - Die erfindungsgemäße Ausbildung des elektrischen Steckerverbinders ermöglicht eine einfache und kostengünstige Herstellung sowie ein einfaches Recycling desselben. Auf entsprechend hergestellten Leiterplatten montierte Verbindungselemente des erfindungsgemäßen Steckerverbinders können ohne vorherige Demontage recycelt werden. Zur Herstellung des Steckerverbinders müssen keine gesonderten Metallteile gefertigt werden.

Zweckmäßigerweise ist die chemisch metallisierbare Oberfläche des ersten thermoplastischen Kunststoffs, vorzugsweise durch Ätzen, aufgerauht und mit Metallkeimen belegt. Das Ätzen kann beispielsweise durch Tauchen in Chromschwefelsäure erfolgen. Die Metallkeime können aus Palladium, Gold oder Silber gebildet sein. Der erste thermoplastische Kunststoff kann aber auch so ausgewählt sein, daß er aufgrund seiner besonderen Materialeigenschaften unmittelbar chemisch metallisierbar ist.

Zweckmäßigerweise ist das Trägerstück zumindest abschnittsweise mit einem zweiten, elektrisch isolierenden thermoplastischen Kunststoff beschichtet. Das erhöht die Funktionssicherheit und ermöglicht eine besonders platzsparende Bauweise des elektrischen Steckerverbinders.

Von herstellungstechnischem Vorteil ist es, daß die Oberfläche des zweiten thermoplastischen Kunststoffs nicht chemisch metallisierbar ist. So kann ein aus einem ersten und zweiten thermoplastischen Kunststoff hergestelltes Verbindungselement einem gemeinsamen Metallisierungsverfahren unterzogen werden.
Nach einem Ausgestaltungsmerkmal ist das Trägerstück aus einer Platte gebildet, an deren einem Rand senkrecht dazu verlaufende Einschnitte vorgesehen sind, so daß der zwischen zwei nebeneinander liegenden Einschnitten verbleibende Plattenabschnitt jeweils ein Kontaktelement bildet.

Nach einem weiteren Ausgestaltungsmerkmal kann die zumindest abschnittsweise metallisierbare Oberfläche des ersten thermoplastischen Kunststoffs mit mindestens einer Metallschicht versehen sein. Die Metallschicht kann aus Kupfer oder Nickel hergestellt sein. Darauf kann eine weitere, beispielsweise aus Silber, Gold, Zinn, Chrom oder Palladium hergestellte, Metallschicht vorgesehen sein.

Es hat sich als günstig erwiesen, daß der erste thermoplastische Kunststoff aus der folgenden Gruppe ausgewählt ist: Acrylnitryl-Butadien-Styrol, Polyamid, Polycarbonat, Polystyrol.

Zur Sicherstellung eines guten elektrischen Kontaktes ist es zweckmäßig, daß die Federzungen sich vom Trägerstück in einer ersten Ebene erstrecken, die parallel zu einer zweiten, durch die Kontaktseite des Kontaktelementes definierten Ebene ist. Die Federzungen können aus den ersten oder zweiten thermoplastischen Kunststoff hergestellt sein. Sie können versetzt zum Kontaktelement angeordnet sein. Nach einem weiteren Ausgestaltungsmerkmal weist das Kontaktelement an seiner Kontaktseite einen, vorzugsweise konvex geformten, Vorsprung auf. Diese Maßnahme dient der Sicherstellung eines guten elektrischen Kontaktes.

Von herstellungstechnischem Vorteil ist es, das Trägerstück und das Kontaktelement einstückig im Spritzgußverfahren herzustellen. Dabei wird es als besonders vorteilhaft angesehen, daß das erste Verbindungselement Bestandteil einer im Spritzgußverfahren hergestellten Baugruppe ist. - Eine solche Baugruppe kann eine Mehrzahl an erfindungsgemäßen Verbindungselementen, Leiterbahnen, Buchsen oder Tasten und dgl. aufweisen. Die Baugruppe kann mit dem ersten Verbindungselement in einstückiger Ausbildung hergestellt sein. Der durch Bestücken und Montage bedingte Mehraufwand entfällt in diesem Fall.

Beim Spritzgußverfahren kann es sich um ein 2-Komponenten-Spritzgußverfahren handeln, wobei die eine Komponente der erste thermoplastische Kunststoff und die andere Komponente der zweite thermoplastische Kunststoff ist.

### Elektrischer Taster

Nach Maßgabe der Erfindung ist vorgesehen, daß das erste und das zweite Kontaktelement aus einem ersten thermoplastischen Kunststoff hergestellt sind, dessen Oberfläche zumindest abschnittsweise chemisch metallisierbar ist. - Die erfindungsgemäße Ausbildung des Tasters ermöglicht eine einfache und kostengünstige Herstellung sowie ein einfaches Recycling desselben. Er kann gemeinsam mit einer entsprechend ausgebildeten Leiterplatte gefertigt werden.
Der durch Bestückung und Montage bedingte Mehraufwand entfällt.

Zweckmäßigerweise ist die chemisch metallisierbare Oberfläche des ersten thermoplastischen Kunststoffs, vorzugsweise durch Ätzen, aufgerauht und mit Metallkeimen belegt. Das Ätzen kann beispielsweise durch Tauchen in Chromschwefelsäure erfolgen. Die Metallkeime können aus Palladium, Gold oder Silber gebildet sein. Der erste thermoplastische Kunststoff kann aber auch so ausgewählt sein, daß er aufgrund seiner besonderen Materialeigenschaften unmittelbar chemisch metallisierbar ist.

Nach einem Ausgestaltungsmerkmal sind das erste und/oder das zweite Kontaktelement zumindest abschnittsweise von einem zweiten, elektrisch isolierenden thermoplastischen Kunststoff umgeben. Das erhöht die Funktionssicherheit und ermöglicht eine besonders platzsparende Bauweise.

Von herstellungstechnischem Vorteil ist es, daß die Oberfläche des zweiten thermoplastischen Kunststoffs nicht chemisch metallisierbar ist. So kann ein aus einem ersten und zweiten thermoplastischen Kunststoff gebildeter Taster einem gemeinsamen Metallisierungsverfahren unterworfen werden.

Nach einem weiteren Ausgestaltungsmerkmal kann die zumindest abschnittsweise metallisierbare Oberfläche des ersten thermoplastischen Kunststoffs mit mindestens einer Metallschicht versehen sein. Die Metallschicht kann aus Kupfer oder Nickel hergestellt sein. Darauf kann eine weitere, beispielsweise aus Silber, Gold, Zinn, Chrom oder Palladium hergestellte Metallschicht vorgesehen sein.

Vorteilhafterweise ist der erste thermoplastische Kunststoff aus der folgenden Gruppe ausgewählt: Acrylnitryl-Butadien-Styrol, Polyamid, Polycarbonat, Polystyrol. Auch der zweite thermoplastische Kunststoff kann aus der vorgenannten Gruppe ausgewählt sein.

Hinsichtlich der Formgebung des elektrischen Tasters wird es als vorteilhaft angesehen, daß das zweite Kontaktelement so geformt ist, daß es entgegen einer durch die elastischen Eigenschaften des ersten und zweiten thermoplastischen Kunststoffs gegebenen elastischen Rückstellkraft mit dem ersten Kontaktelement in Berührung bringbar ist. Das erste und/oder das zweite Kontaktelement können einen konvex geformten Kontaktkörper aufweisen. Zweckmäßigerweise ist das erste und das zweite Kontaktelement einstückig ausgebildet.

Von fertigungstechnischem Vorteil ist es, das erste und das zweite Kontaktelement im Spritzgußverfahren herzustellen. Dabei wird es als besonders vorteilhaft angesehen, daß der Taster Bestandteil einer ebenfalls im Spritzgußverfahren hergestellten Baugruppe ist. - Eine solche Baugruppe kann mehrere Taster, Leiterbahnen, Buchsen, Stecker oder dgl. aufweisen.
Beim vorerwähnten Spritzgußverfahren kann es sich um ein 2-Komponenten-Spritzgußverfahren handeln, wobei die eine Komponente der erste thermoplastische Kunststoff und die andere Komponente der zweite thermoplastische Kunststoff ist. Schließlich kann nach einer weiteren Ausgestaltung die Baugruppe mit dem Taster in einstückiger Ausbildung hergestellt sein.

### Elektrische Anschlußbuchse

Nach Maßgabe der Erfindung ist vorgesehen, daß das Kontaktstück und das Trägerstück aus einem ersten thermoplastischen Kunststoff hergestellt ist, dessen Oberfläche zumindest abschnittsweise chemisch metallisierbar ist. - Die erfindungsgemäße Ausbildung der elektrischen Anschlußbuchse ermöglicht eine einfache und kostengünstige Herstellung sowie ein einfaches Recycling derselben. Sie kann gemeinsam mit einer entsprechend hergestellten Leiterplatte gefertigt werden. Der durch Bestücken und Montage bedingte Mehraufwand entfällt.

Zweckmäßigerweise ist die chemisch metallisierbare Oberfläche des ersten thermoplastischen Kunststoffs, vorzugsweise durch Ätzen, aufgerauht und mit Metallkeimen belegt. Das Ätzen kann beispielsweise durch Tauchen in Chromschwefelsäure erfolgen. Die Metallkeime können aus Palladium, Gold oder Silber gebildet sein. Der erste thermoplastische Kunststoff kann aber auch so ausgewählt sein, daß er aufgrund seiner besonderen Materialeigenschaften unmittelbar chemisch metallisierbar ist.

Nach einem Ausgestaltungsmerkmal ist/sind das Kontaktstück und/oder das Trägerstück zumindest abschnittsweise mit einem zweiten, elektrisch isolierenden thermoplastischen Kunststoff beschichtet. Das erhöht die Funktionssicherheit und ermöglicht eine besonders platzsparende Bauweise.
Von herstellungstechnischem Vorteil ist es, daß die Oberfläche des zweiten thermoplastischen Kunststoffs nicht chemisch metallisierbar ist. So kann eine aus einem ersten und zweiten thermoplastischen Kunststoff gebildete Anschlußbuchse einem gemeinsamen Metallisierungsverfahren unterworfen werden.

Nach einem weiteren Ausgestaltungsmerkmal kann die zumindest abschnittsweise metallisierbare Oberfläche des ersten thermoplastischen Kunststoffs mit mindestens einer Metallschicht versehen sein. Die Metallschicht kann aus Kupfer oder Nickel hergestellt sein. Darauf kann eine weitere, beispielsweise aus Silber, Gold, Zinn, Chrom oder Palladium hergestellte Metallschicht vorgesehen sein.

Vorteilhafterweise ist der erste thermoplastische Kunststoff aus der folgenden Gruppe ausgewählt: Acrylnitryl-Butadien-Styrol, Polyamid, Polycarbonat, Polystyrol. Auch der zweite thermoplastische Kunststoff kann aus der vorgenannten Gruppe ausgewählt sein.
Nach einem weiteren Ausgestaltungsmerkmal weist das Kontaktstück einen sich vom Trägerstück erstreckenden Rohrabschnitt und zweckmäßigerweise eine Mehrzahl von sich vom Trägerstück erstreckenden Vorsprüngen auf. Die Vorsprünge sind so ausgebildet, daß sie einen Kontaktstift eines in die Anschlußbuchse eingesteckten Steckers klemmend halten.

Vorteilhafterweise ist die Innenwand des Rohrabschnitts zumindest abschnittsweise mit dem zweiten thermoplastischem Kunststoff beschichtet.

Nach einem weiteren Ausgestaltungsmerkmal kann das Trägerstück plattenartig ausgebildet sein und das Kontaktstück sich senkrecht von der Plattenober-und/oder Unterseite erstrecken.
Von herstellungstechnischem Vorteil ist es, das Trägerstück und das Kontaktstück einstückig im Spritzgußverfahren herzustellen. Dabei wird es als besonders vorteilhaft angesehen, daß das Spritzgußverfahren ein 2-Komponenten-Spritzgußverfahren ist, wobei die eine Komponente der erste thermoplastische Kunststoff und die andere Komponente der zweite thermoplastische Kunststoff ist.

### Verfahren zur Metallisierung von Kunststoffoberflächen

Nach Maßgabe der Erfindung ist ein Verfahren zur Metallisierung einer Kunststoffoberfläche mit folgenden Schritten vorgesehen:
a) zumindest abschnittsweises Aktivieren der Oberfläche mittels Koronabehandlung,
b) Belegen der aktivierten Oberfläche mit Metallkeimen und
c) Galvanisieren der Oberfläche.

Nach der Erfindung kann überraschenderweise auf die Erzeugung einer oberflächlichen Mikrorauhigkeit mittels Ätzen verzichtet werden. Die statt dessen erfolgende Aktivierung der Oberfläche mittels Koronabehandlung ist einfach und kostengünstig durchführbar; sie ist umweltverträglich.

Unter Koronabehandlung wird ein physikalisches Oberflächenbehandlungsverfahren verstanden, bei dem durch Beschießen der Oberfläche mit Elektronen und Ionen in den obersten Molekülschichten Ladungsveränderungen entstehen. Die Koronabehandlung findet im Prinzip als Hochspannungsfunkenentladung zwischen zwei Elektroden statt. Die Entladung erfolgt dabei immer im Luftspalt zwischen den beiden Elektroden. Wesentlich ist die Höhe der Spannung. Je höher diese ist, desto größere Abstände können überbrückt werden. Das ist insbesondere für die Behandlung von Formteilen wichtig. Üblicherweise wird zur Erzeugung einer Korona mit Hochfrequenzhochspannung gearbeitet, die im Bereich von 5 bis 15 kV mit einer Frequenz im Bereich zwischen 15 und 30 kHz liegt.

Nach einem Ausgestaltungsmerkmal wird beim Schritt lit. b
b1) die Oberfläche in ein erste Metallionen enthaltendes erstes Bad getaucht und anschließend werden
b2) die an der Oberfläche anhaftenden ersten Metallionen durch Tauchen in eine zweites ein Metallborhydrid enthaltendes Bad reduziert. - Die damit erzeugten Metallkeime erleichtern eine chemische Metallisierung der Oberfläche.

Nach dem Schritt lit. b kann die Oberfläche durch Tauchen in ein drittes Bad chemisch metallisiert werden. Beim Dritten Bad kann es sich z.B. um ein chemisch reduktives Kupferbad auf Tartratbasis handeln.

Als erste Metallionen werden vorzugsweise Palladium-, Gold- oder Silberionen, als Metallborhydrid zweckmäßigerweise wasserlösliches Natriumborhydrid verwendet.

Das vorgeschlagene Verfahren eignet sich insbesondere zur Herstellung eines elektrischen Bauelements im 2-Komponenten Spritzgußverfahren, bei dem die eine Komponente aus einem ersten thermoplastischen Kunststoff und die andere Komponente aus einem zweiten thermoplastischen Kunststoff gespritzt wird, und wobei die Oberfläche des ersten thermoplastischen Kunststoffs vor dem Spritzen des zweiten thermoplastischen Kunststoffs, vorzugsweise vollflächig, aktiviert wird. - Ein solches Bauelement läßt sich besonders umweltverträglich herstellen und entsorgen. Die vollflächige Aktivierung der Oberfläche des ersten thermoplastischen Kunststoffs erleichtert weiter die Herstellung des Bauelements. Der erste thermoplastische Kunststoff kann zumindest abschnittsweise mit dem zweiten thermoplastischen Kunststoff umspritzt werden. Vorteilhafterweise ist die Oberfläche des zweiten thermoplastischen Kunststoffs nicht unmittelbar metallisierbar und zweckmäßigerweise elektrisch isolierend. - So kann auf einfache Weise eine abschnittsweise Metallisierung der freiliegenden Oberfläche des ersten thermoplastischen Kunststoffs erreicht werden. Die elektrische isolierenden Eigenschaften des zweiten thermoplastischen Kunststoffs wirken der Entstehung von Kurzschlüssen entgegen.

Beim Schritt lit. c kann der aus dem ersten und zweiten thermoplastischen Kunststoff hergestellte Formling galvanisiert werden. - Das vereinfacht weiter die Herstellung.

Der erste und/oder zweite thermoplastische Kunststoff können aus der folgenden Gruppe ausgewählt sein: Acrylnitryl-Butadien-Styrol, Polyamid, Polycarbonat, Polystyrol oder
Polyethylen. Der erste und der zweite thermoplastische Kunststoff können insbesondere aus demselben Material hergestellt sein. Sie unterscheiden sich dann nur hinsichtlich der Aktivierung ihrer Oberfläche.

Nachfolgend wird ein Ausführungsbeispiel des Verfahrens näher erläutert.

Ein mit einer Metallisierung zu versehendes aus einem ersten thermoplastischen Kunststoff hergestelltes Bauteil wird vollflächig mit Korona behandelt. Zur Erzeugung der Korona werden zwei etwa 5 mm von der Oberfläche beabstandete Elektroden mit einer Hochfrequenzhochspannung von etwa 7 kV beaufschlagt.
Die Behandlungsdauer beträgt 4 Sekunden.

Anschließend wird die aktivierte Oberfläche des Bauteils mit Palladium-Keimen belegt. Dazu wird das Bauteil in eine Palladiumionen-haltige Lösung getaucht.
Dann erfolgt eine Reduktion der an der aktivierten Oberfläche anhaftenden Palladiumionen durch Tauchen des Bauteils in eine NaBH₄ (1g/l)/ NaOH (5g/l) enthaltende weitere Lösung.

Das so vorbehandelte Bauteil wird dann abschnittsweise mit einem zweiten thermoplastischen Kunststoff umspritzt. Der zweite thermoplastische Kunststoff besteht aus einem elektrisch isolierenden Material, z.B. Polyethylen. Seine Oberfläche ist nicht metallisierbar.
Der aus einem ersten und einem zweiten thermoplastischen Kunststoff unterschiedlicher Oberflächenqualität bestehende Formling wird anschließend einer chemischen Metallisierung durch Tauchen in ein chemisch reduktives Kupferbad auf Tartratbasis unterworfen. Die Metalle scheiden sich nur an den mit Palladium-Keimen besetzten aktivierten Oberflächen ab. Die im Bereich der freiliegenden aktivierten Oberfläche aufgebrachte etwa 0,5 µm dicke Kupferschicht wird in einem weiteren Verfahrensschritt mittels einer galvanischen Kupfermetallisierung in ihrer Dicke verstärkt. Dazu wird der Formling in ein saures Kupferelektrolyt, z.B. Cupracid der Firma Atotech, enthaltendes Bad getaucht.

Auf diese Weise kann umweltverträglich ein elektrisches Bauelement einfach und kostengünstig hergestellt werden.

Nachfolgend werden Ausführungsbeispiele der Erfindung anhand der Zeichnung näher erläutert. Hierin zeigen
- Fig. 1: eine Draufsicht auf den ersten Spritzling der Bedieneinheit,
- Fig. 2: eine Draufsicht auf den zweiter Spritzling der Bedieneinheit,
- Fig. 3: eine Ansicht der Unterseite des ersten Spritzlings der Bedieneinheit,
- Fig. 4: eine Ansicht der Unterseite des zweiter Spritzlings der Bedieneinheit,

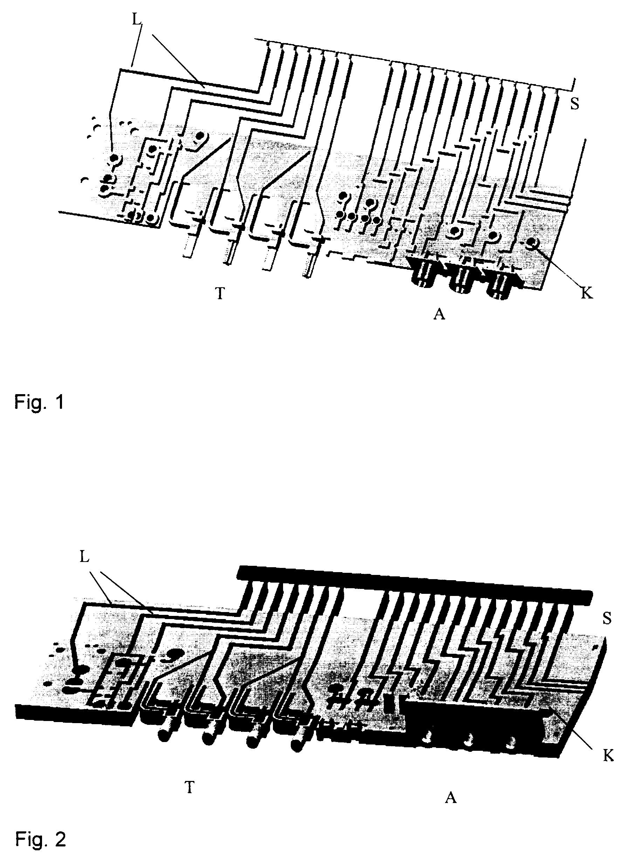

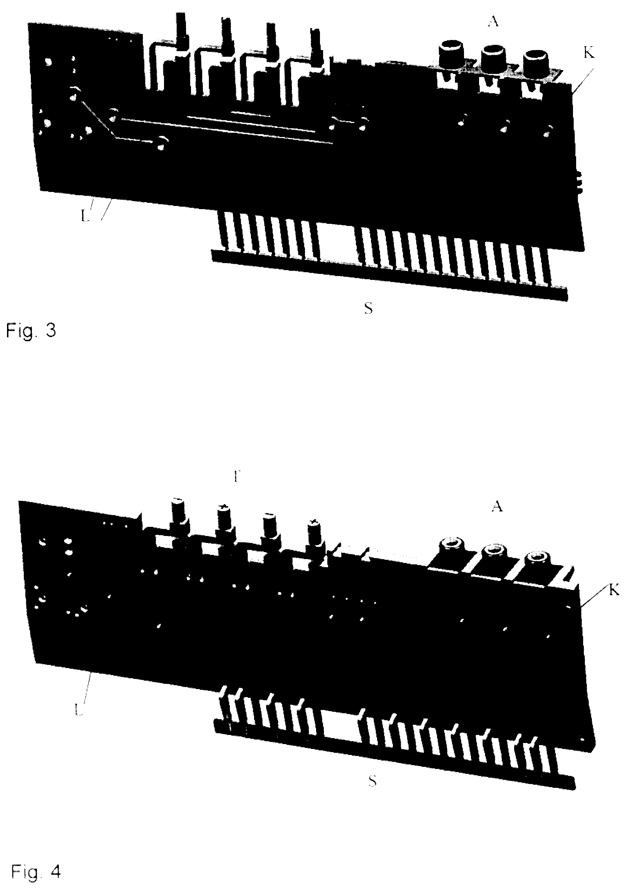

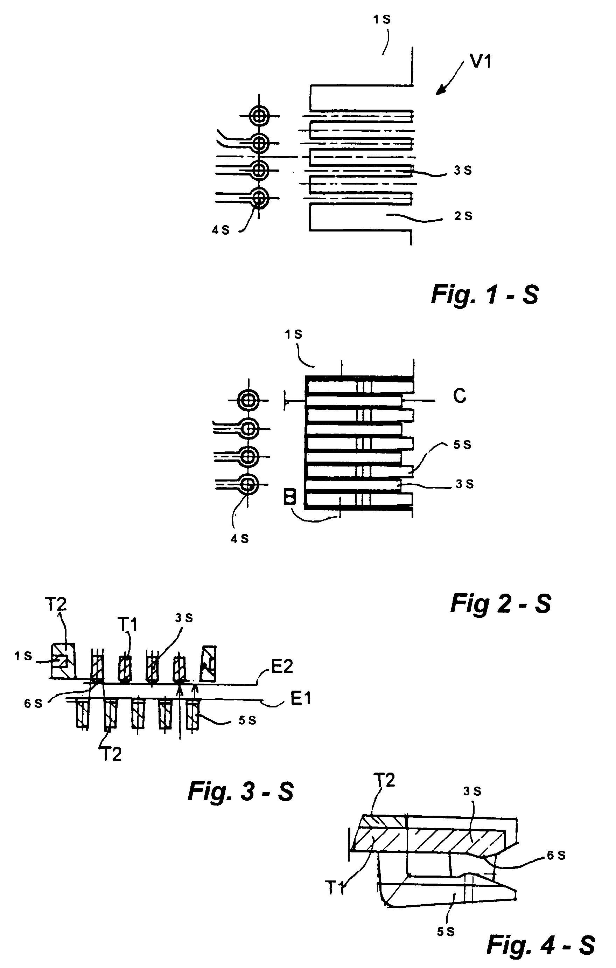

- FIG. 1-S: eine Draufsicht eines aus dem ersten thermoplastischen Kunststoff hergestellten Bestandteils eines ersten Verbindungselements,
- FIG. 2-S: eine Draufsicht der aus dem ersten und zweiten thermoplastischen Kunststoff hergestellten Bestandteile des ersten Verbindungselements,
- FIG. 3-S: eine Schnittansicht gemäß der Schnittlinie B-B in FIG. 2,
- FIG. 4-S: eine Schnittansicht gemäß der Schnittlinie C-C in FIG. 2

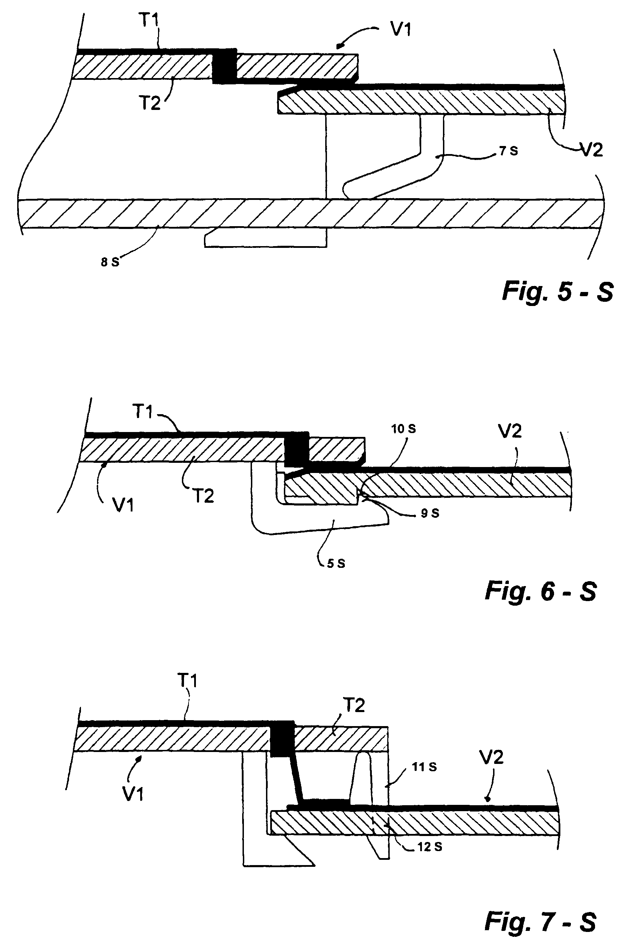

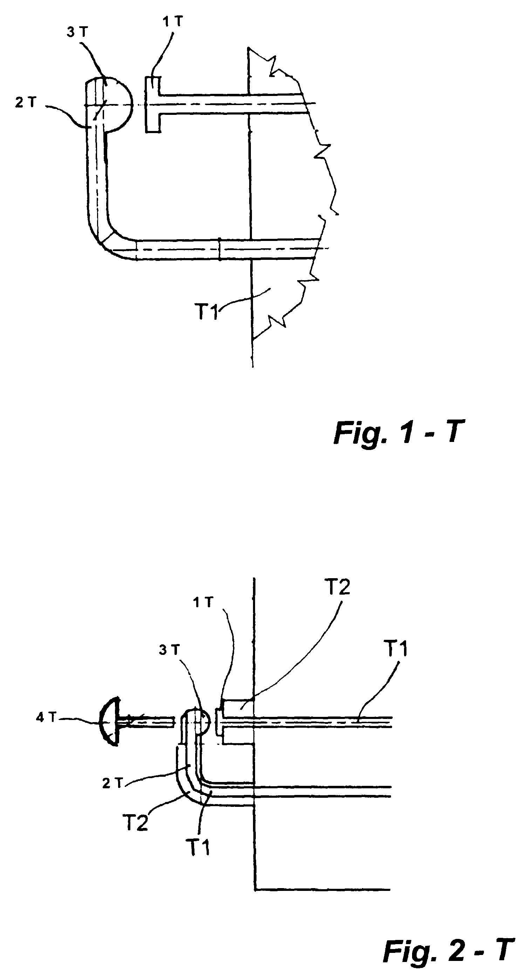

- FIG. 5-S: eine Querschnittsansicht eines zweiten Steckerverbinders,

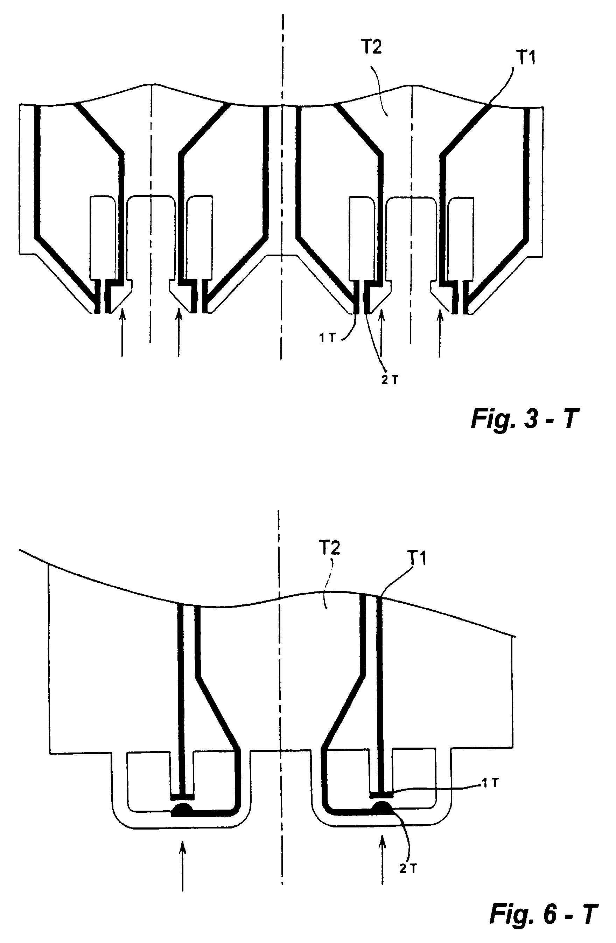

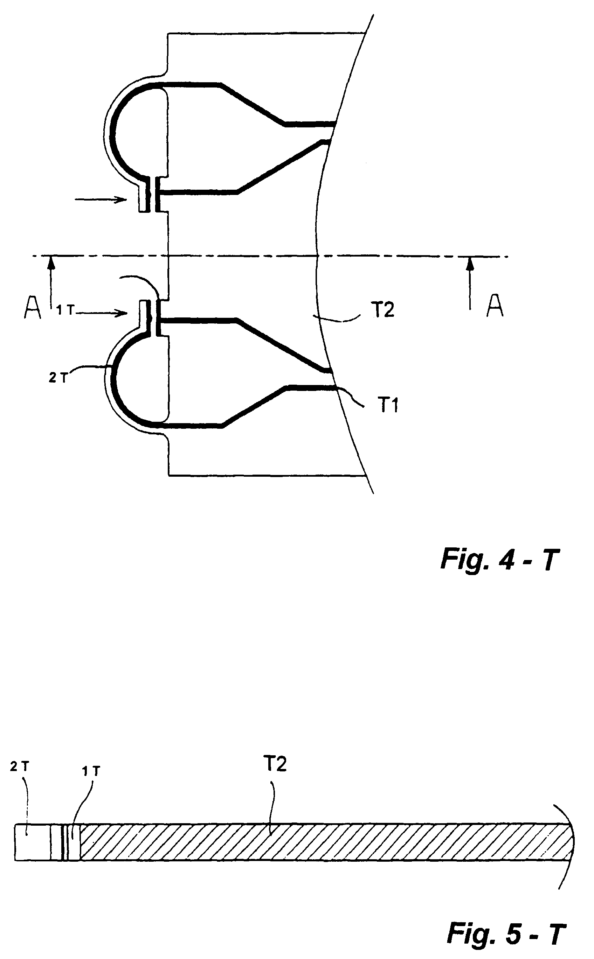

- FIG. 6-S: eine Querschnittsansicht eines dritten Steckerverbinders,

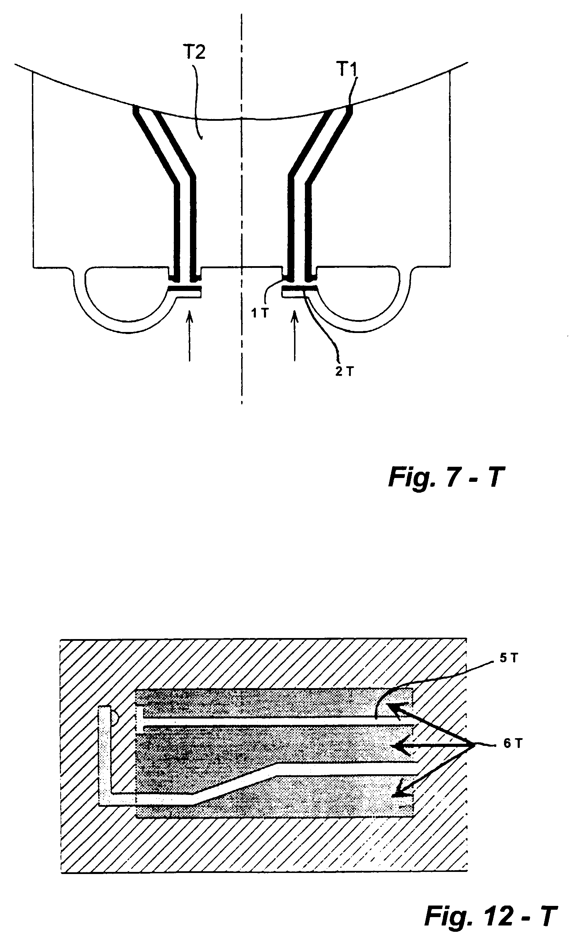

- FIG. 7-S: eine Querschnittsansicht eines vierten Steckerverbinders,
- FIG. 1-T: eine schematische Querschnittsansicht der aus dem ersten thermoplastischen Kunststoff gebildeten Bestandteile eines ersten Tasters,
- FIG. 2-T: den Taster nach FIG. 1-T mit den aus dem ersten und dem zweiten thermoplastischen Kunststoff hergestellten Bestandteilen,
- FIG. 3-T: eine schematische Querschnittsansicht eines zweiten Tasters,
- FIG. 4-T: eine schematische Querschnittsansicht eines dritten Tasters,
- FIG. 5-T: eine Schnittansicht gemäß der Schnittlinie A-A in FIG. 4-T,
- FIG. 6-T: eine schematische Querschnittsansicht eines vierten Tasters,
- FIG. 7-T: eine schematische Querschnittsansicht eines fünften Tasters,

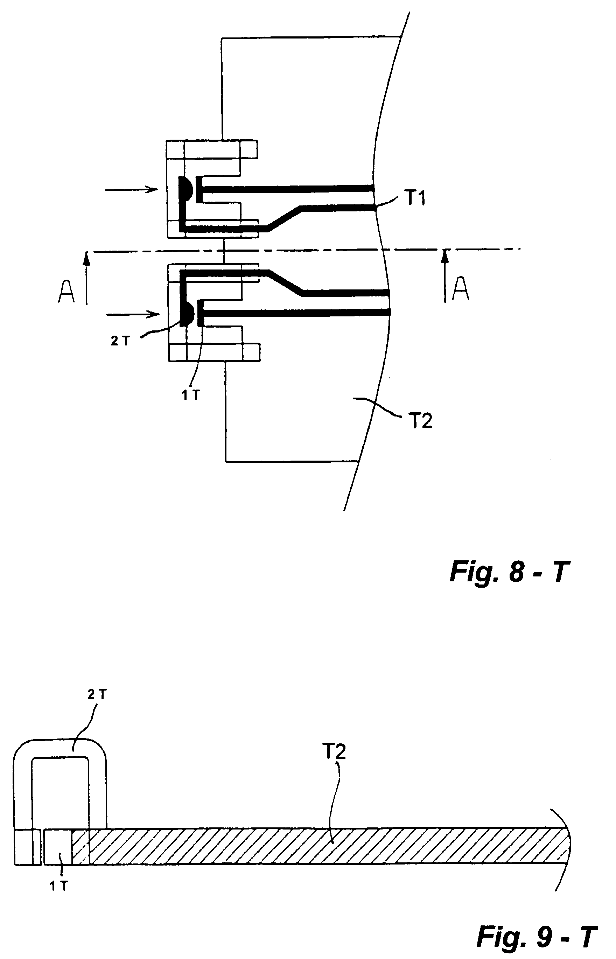

- FIG. 8-T: eine schematische Querschnittsansicht eines sechsten Tasters,
- FIG. 9-T: eine Schnittansicht gemäß der Schnittlinie A-A in FIG. 8-T,

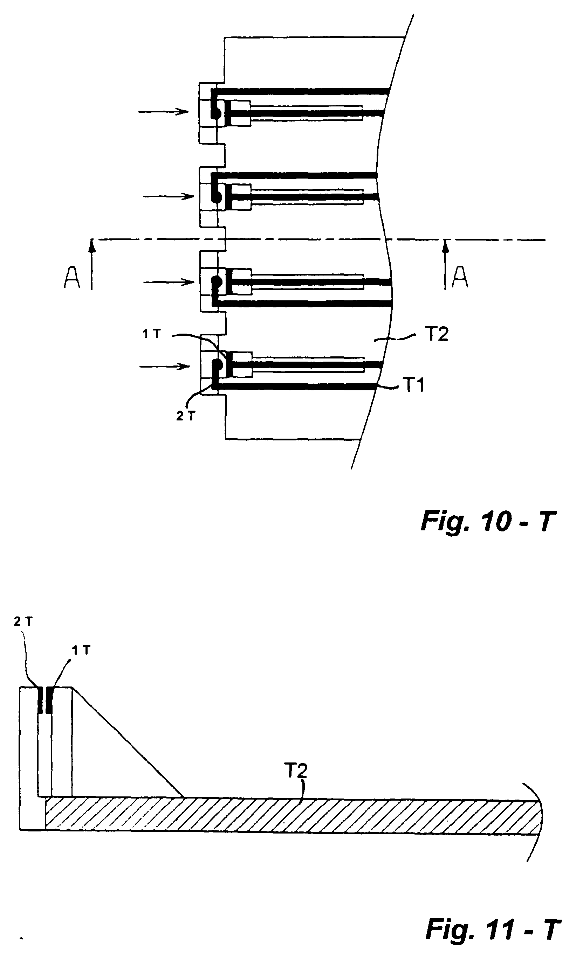

- FIG. 10-T: eine schematische Querschnittsansicht eines siebten Tasters,
- FIG. 11-T: eine Schnittansicht gemäß der Schnittlinie A-A in FIG. 10,

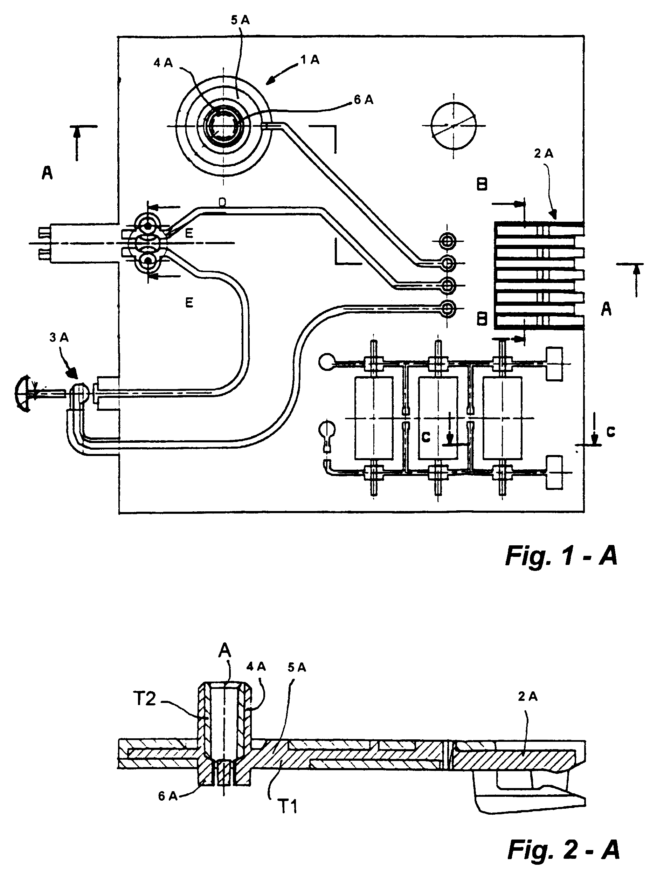

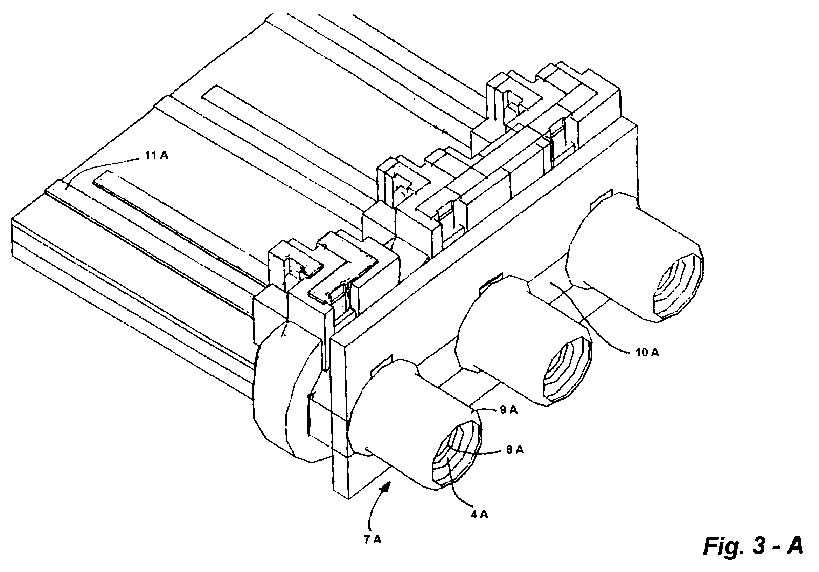

- FIG. 12-T: eine schematische Draufsicht auf ein Spritzgußwerkzeug,
- FIG. 1-A: eine Draufsicht auf eine Baugruppe mit einer elektrischen Anschlußbuchse,
- FIG. 2-A: eine Schnittansicht entlang der Schnittlinie A-A in FIG. 1 und
- FIG. 3-A: eine perspektivische Darstellung einer weiteren Baugruppe.

### Bedieneinheit

Fig. 1 zeigt eine Ansicht des ersten Spritzlings der Bedeineinheit. Der sogenannte erste Spritzling wird in einer Kunststoff-Spritzform hergestellt und weist die zentralen Merkmale der Bedeineinheit auf. Diese sind Leiterbahnen (L), elektrische Kontaktflächen (K), Grundkörper für elekrtische Taster (T), Grundkörper elektrischer Anschlußbuchsen (A) und Grundkörper elektrischer Steckerverbinder (V) auf. Fig. 3 zeigt den ersten Spritzling der Bedieneinheit von unten. Die Stellen der Bedieneinheit, welche leitfähig gemacht werden sollen werden anschließend metallisiert. Hierzu werden diese Stellen vorbehandelt. Anschließend werden diese Stellen mittels eines zweiten Kunststoffes voneinander getrennt und isoliert und mit Kunststoff verfüllt. Fig. 2 und Fig. 4 zeigen einen zweiten Spritzling, bei welchem diese Arbeitsschritte erfolgt sind.
Anschließend werden die Stellen, an denen der Kunststoff des ersten Spritzlings nicht vom zweiten Kunststoff abgedeckt ist, metallisiert.
Auf diese Weise werden direkt auf bzw. mit dem Bedienteil elektrische Durchkontaktierungen (K), Leiterbahnen (L), elektrische Steckerverbinder (S), elektrische Taster (T), elektrische Anschlußbuchsen (A) erzeugt. Diese Elemente werden im weiteren genauer beschrieben

### Steckerverbinder

FIG. 1-S zeigt eine Draufsicht des aus dem ersten thermoplastischen Kunststoff T1 hergestellten Bestandteils eines ersten Verbindungselements V1. Ein Trägerstück 1 ist aus einer Platte gebildet. Am Rand der Platte sind senkrecht dazu verlaufende Einschnitte 2S vorgesehen. Jeweils zwischen zwei benachbarten Einschnitten 2S ist ein zungenförmiges Kontaktelement 3S gebildet. Das Trägerstück 1S weist außerdem eine Mehrzahl an ersten Durchbrüchen 4S auf.

In FIG. 2-S ist eine Draufsicht auf die aus dem ersten T1 und dem zweiten thermoplastischen Kunststoff T2 gebildeten Bestandteile des ersten Verbindungselementes V1 gezeigt. Wie insbesondere aus den Schnittdarstellungen der FIG. 3-S und 4-S deutlich wird, sind die Kontaktelemente 3S aus dem ersten thermoplastischen Kunststoff T1 gebildet. Das Trägerstück 1S ist im übrigen mit einem zweiten thermoplastischen Kunststoff T2 umspritzt. Aus FIG. 4-S ist ersichtlich, daß sich die Federzungen 5S in einer ersten Ebene E1 vom Trägerstück 1S erstecken. Die erste Ebene E1 ist parallel zu einer zweiten Ebene E2, die durch die Kontaktseiten der Kontaktelemente 3S definiert ist. An der Kontaktseite der Kontaktelemente 3S sind konvex geformte Kontaktkörper 6S vorgesehen.

Die FIG.5-S bis 7-S zeigen Querschnittsansichten verschiedener Ausführungsbeispiele, bei denen jeweils zwei Verbindungselementen V1 und V2 zusammengesteckt sind. Wie aus FIG.5-S ersichtlicht ist, kann das Verbindungselement V2 an der der Kontaktseite gegenüberliegenden Seite eine angespritztes Federelement 7S aufweisen, welches die Kontaktseiten der Verbindungselemente V1 und V2 gegeneinander zwingt. Dazu stützt sich das Federelement auf einer mit dem ersten Verbindungselement V1 fest verbundnen Platte 8S ab.

In FIG. 6-S ist an der Federzunge 5S des einen Verbindungselements V1 ein Rastvorsprung 9S vorgesehen, der in eine korrespondierende Ausnehmung 10S an der Unterseite des zweiten Verbindungselements V2 eingreift. Bei der in FIG. 7-S gezeigten Variante durchgreift ein sich vom einen Verbindungselement V1 ersteckendes Rastelement 11S einen am anderen Verbindungselement V2 vorgesehenen zweiten Durchbruch 12S. Das andere Verbindungselement V2 ist auf einem sich vom einen Verbindungselement V1 erstreckenden hakenartigen Fortsatz 13S abgestützt.

### Elektrischer Taster

In FIG. 1 -T sind die aus dem ersten thermoplastischen Kunststoff T1 gebildeten Bestandteile eines ersten Tasters in einer schematischen Querschnittsansicht gezeigt. Ein erstes Kontaktelement 1T ist stempelförmig ausgebildet.
Gegenüberliegend ist ein zweites Kontaktelement 2T angeordnet, das einen konvex geformten Kontaktkörper 3T aufweist. Das zweite Kontaktelement 2T weist eine Umbiegung um etwa 90 Grad auf.

In FIG. 2-T sind die aus dem ersten T1 und dem zweiten thermoplastischen Kunststoff T2 hergestellten Bestandteile des Tasters nach FIG. 1-T gezeigt. Die aus dem zweiten thermoplastischen Kunststoff T2 gebildeten Bestandteile umgeben das erste 1T und das zweite Kontaktelement 2T abschnittsweise. Ein Bedienelement 4T ist zur Übertragung einer Tastbewegung auf das zweite Kontaktelement 2T beweglich angebracht.

In den FIG. 3-T bis 11-T sind weitere Ausführungsbeispiele gezeigt. Die aus dem ersten thermoplastischen Kunststoff T1 hergestellten Bestandteile sind dabei in den schematischen Querschnittsansichten mit schwarzer Farbe gekennzeichnet.
Wie aus FIG. 8-T ersichtlich ist, kann das zweite Kontaktelement 2T auch zwei Umbiegungen um 90° aufweisen.

FIG. 12-T zeigt schließlich eine Draufsicht auf ein Spritzgußwerkzeug. Mit 5T ist eine erste Kavität bezeichnet, welche mit dem ersten thermoplastischen Kunststoff T1 ausgespritzt wird. Eine zweite Kavität 6T ist für den zweiten thermoplastischen Kunststoff T2 vorgesehen.

Zur Herstellung einer den erfindungsgemäßen elektrischen Taster aufweisenden Baugruppe wird im 2-Komponenten Spritzgußverfahren zunächst ein aus einem ersten Thermoplasten T1 bestehender Vorformling gespritzt. Der erste Thermoplast T1 ist unmittelbar chemisch metallisierbar oder kann durch geeignete Maßnahmen, z.B. chemisches Ätzen und nachfolgendes Belegen mit Palladiumkeimen, chemisch metallisierbar gemacht werden. Zur Herstellung eines Formlings wird der Vorformling zumindest abschnittsweise mit einem zweiten thermoplastischen Kunststoff T2 umspritzt. Der zweite thermoplastische Kunststoff T2 ist elektrisch isolierend ausgebildet. Er ist nicht unmittelbar metallisierbar.

Sodann wird der Formling einer chemischen Metallisierung unterzogen. Dazu wird der Formling in eine Metallionen, wie Kupferionen, enthaltende Lösung getaucht.
Die Metallionen haften nur an der metalliserbaren Oberfläche des ersten Thermoplasten T1. Dadurch können komplexe elektrisch leitende Strukturen realisiert werden. Ein solchermaßen hergestellter Taster oder eine einen solchen Taster umfassende Baugruppe ist einfach und schnell herstellbar. Sie ist insbesondere ohne großen Aufwand recycelbar.

Im weiteren können die Taster mit einer Beschriftung versehen werden. Hierzu wird im ersten Kunststoff T1 die Beschriftung, beispielsweise ein Plus-Zeichen, ein Minuszeichen, als zu metallisierende Fläche markiert. Beim Metallisieren werden diese Zeichen deutlich erkennbar. Die metallisierte Oberfläche wird durch den zweiten Kunststoff T2 von den weiteren leitenden Flächen isoliert. Anschließend werden diese metallisierten Oberflächen veredelt und vor Korrosion geschützt.

### Elektrische Anschlußbuchse

FIG. 1-A zeigt eine Draufsicht auf eine Baugruppe mit einer elektrischen Anschlußbuchse 1A. Als weitere Bestandteile der Baugruppe sind ein Steckerelement 2A und ein Taster 3A erkennbar. Wie insbesondere in Zusammensicht FIG. 2-A ersichtlich ist, besteht die Anschlußbuchse 1A aus einem Rohrabschnitt 4A, welcher sich senkrecht von einem plattenartig ausgebildeten Trägerstück 5A erstreckt. Ferner erstrecken sich vom Trägerstück 5A vier Vorsprünge 6A in radialer Anordnung zur Rohrachse A. Der Rohrabschnitt 4A, die Vorsprünge 6A sowie das Trägerstück 5A sind aus einem ersten thermoplastischen Kunststoff T1 hergestellt. Der Rohrabschnitt 4A ist an seiner Innenwand mit einem zweiten thermoplastischen Kunststoff T2 beschichtet. Auch das Trägerstück 5A ist abschnittsweise mit dem zweiten thermoplastischen Kunststoff T2 beschichtet.

FIG. 3-A zeigt eine perspektivische Darstellung einer weiteren Baugruppe. Die Baugruppe umfaßt drei Cinch-Buchsen 7A. Das Kontaktelement ist im wesentlichen aus einem Rohrabschnitt 4A gebildet. An der Innenwand des Rohrabschnitts 4A ist eine aus dem zweiten thermoplastischen Kunststoff gebildete Isolationsschicht 8A vorgesehen. Der Rohrabschnitt 4A ist von einer Metallhülse 9A umgeben. Die Metallhülsen 9A sind mit einer ersten Leiterbahn 10A elektrisch miteinander verbunden. Zweite Leiterbahnen 11A sind mit den (hier nicht sichtbaren) Vorsprüngen 6A jeder Cinch-Buchse 7A verbunden.

Die Baugruppe wird folgendermaßen hergestellt:
Es wird zunächst eine für das 2-Komponenten-Spritzgußverfahren geeignete Spritzgußform bereitgestellt. Dann wird eine aus dem ersten thermoplastischen Kunststoff T1 gebildeter Vorformling gespritzt. Dieser umfaßt Bestandteile, die später zumindest abschnittsweise elektrisch leitfähig sein sollen. Dazu gehören der Rohrabschnitt, die Vorsprünge 6A sowie das Trägerstück 5A. Nachfolgend wird die Oberfläche des Vorformlings abschnittsweise chemisch metallisierbar gemacht werden, indem sie durch chemisches Ätzen aufgerauht und nachfolgend mit Palladiummetallkeimen belegt wird. Es kann aber auch ein erster thermoplastischer Kunststoff verwendet werden, dessen Oberfläche aufgrund seiner Materialeigenschaften unmittelbar chemisch metallisierbar ist.

Sodann wird der Vorformling mit dem zweiten thermoplastischen Kunststoff T2 abschnittsweise umspritzt. Der zweite thermoplastische Kunststoff T2 ist elektrisch isolierend. Seine Oberfläche ist nicht chemisch metallisierbar.

Nachfolgend kann ein aus beiden thermoplastischen Kunststoffen hergestellter Formling einem chemischen Metallisierungsverfahren unterworfen werden. Dazu wird der Formling in eine Kupfermetallionen enthaltende Lösung getaucht. Dabei werden nur die metallisierbaren Oberflächenabschnitte des ersten thermoplastischen Kunststoffs mit einer Metallschicht überzogen.

### Bezugszeichen

- 1 S: Trägerstück
- 2 S: Einschnitt
- 3 S: Kontaktelement
- 4 S: erster Durchbruch
- 5 S: Federzunge
- 6 S: Vorsprung
- 7 S: Federelement
- 8 S: Platte
- 9 S: Rastvorsprung
- 10 S: Ausnehmung
- 11 S: Rastelement
- 12 S: zweiter Durchbruch
- 1 T: erstes Kontaktelement
- 2 T: zweites Kontaktelement
- 3 T: Kontaktkörper
- 4 T: Bedienelement
- 5 T: erste Kavität
- 6 T: zweite Kavität
- 1 A: Anschlußbuchse
- 2 A: Stecker
- 3 A: Taster
- 4 A: Rohrabschnitt
- 5 A: Trägerstück
- 6 A: Vorsprung
- 7 A: Cinch-Buchse
- 8 A: Isolationsschicht
- 9 A: Metallhülse
- 10 A: erste Leiterbahn
- 11 A: zweite Leiterbahn
- V1: erstes Verbindungselement
- V2: zweites Verbindungselement
- E1: erste Ebene
- E2: zweite Ebene
- T1: erster thermoplastischer Kunststoff
- T2: zweiter thermoplastischer Kunststoff
- A: Rohrachse

## Patentansprüche

1. Bedieneinheit mit mindestens einer elektrischen Taste (T), mindestens einer elektrischen Anschlußbuchse (A), mindestens einer Leiterbahn (L), mindestens einer Kontaktstelle (K) und mindestens einer Steckerverbindung (S), **dadurch gekennzeichnet**, daß die Bedieneinheit aus einem ersten thermoplastischen Kunststoff hergestellt ist, dessen Oberfläche zumindest abschnittsweise chemisch metallisierbar ist.

2. Elektrischer Steckverbinder mit zwei Verbindungselementen (V1, V2), wobei ein erstes Verbindungselement (V1) ein Trägerstück (1S) mit mindestens einem Kontaktelement (3S) aufweist, **dadurch gekennzeichnet**, daß das Trägerstück (1S) und das Konaktelement (3S) aus einem ersten thermoplastischen Kunststoff (T1) hergestellt sind, dessen Oberfläche zumindest abschnittsweise chemisch metallisierbar ist.

3. Elektrischer Steckerverbinder nach Anspruch 2, wobei die chemische metallisierbare Oberfläche des ersten thermoplastischen Kunststoffs (T1), vorzugsweise durch Ätzen, aufgerauht und mit Metallkeimen belegt ist.

4. Elektrischer Steckerverbinder nach Anspruch 2 oder 3, wobei das Trägerstück (1S) zumindest abschnittsweise mit einem zweiten, elektrisch isolierenden thermoplastischen Kunststoff (T2) beschichtet ist und die Oberfläche des zweiten thermoplastischen Kunststoffs (T2) nicht chemisch metallisierbar ist.

5. Elektrischer Steckerverbinder nach einem der vorhergehenden Ansprüche 2 bis 4, wobei das Trägerstück (1S) aus einer Platte gebildet ist, an deren einem Rand senkrecht dazu verlaufende Einschnitte (2S) vorgesehen sind, so daß der zwischen zwei nebeneinanderliegenden Einschnitten (2S) verbleibende Plattenabschnitt jeweils ein Konaktelement (1S) bildet.

6. Elektrischer Steckerverbinder nach einem der vorhergehenden Ansprüche 2 bis 5, wobei die zumindest abschnittsweise metallisierbare Oberfläche des ersten thermoplastischen Kunststoffs (T1) mit mindestens einer Metallschicht versehen ist.

7. Elektrischer Steckerverbinder nach einem der vorhergehenden Ansprüche 2 bis 6, wobei der erste thermoplastische Kunststoff (T1) aus der folgenden Gruppe ausgewählt ist: Acrylnitryl-Butadien-Styrol, Polyamid, Polycarbonat, Ploystyrol.

8. Elektrischer Steckerverbinder nach einem der vorhergehenden Ansprüche 2 bis 7, wobei Federzungen (5S) sich vom Trägerstück (1S) in einer ersten Ebene (E1) erstrecken, die parallel zu einer zweiten, durch die Kontaktseite des Kontaktelements (3S) definierten Ebene (E2) ist und die Federzungen (5S) versetzt zum Kontaktelement (3S) angeordnet sind.

9. Elektrischer Steckerverbinder nach einem der vorhergehenden Ansprüche 2 bis 8, wobei das Kontaktelement (3S) an seiner Kontaktseite einen, vorzugsweise konvex geformten, Vorsprung (6S) aufweist und das Trägerstück (1S) und das Kontaktelement (3S) einstückig im Spritzgußverfahren hergestellt sind.

10. Elektrischer Steckerverbinder nach einem der vorhergehenden Ansprüche 2 bis 9, wobei das erste Verbindungselement (V1) Bestandteil einer im Spritzgießverfahren hergestellten Baugruppe ist und die Baugruppe mit dem ersten Verbindungselement (V1) in einstückiger Ausbildung hergestellt ist.

11. Elektrischer Steckerverbinder nach einem der vorhergehenden Ansprüche 2 bis 10, wobei das Spritzgußverfahren ein 2-Komponenten Spritzgußverfahren ist, wobei die eine Komponente der erste thermoplastische Kunststoff (T1) und die andere Komponenete der zweite thermoplastische Kunststoff (T2) ist.

12. Elektrischer Taster mit einem ersten (1T) und einem zweiten Kontaktelement (2T), wobei das zweite Kontaktelement (2T) zum Schließen eines Stromkreises mit dem ersten Kontaktelement (1T) in Kontakt bringbar ist, **dadurch gekennzeichnet**, daß das erste (1T) und das zweite Kontaktelement (2T) aus einem ersten thermoplastischen Kunststoff (T1) hergestellt sind, dessen Oberfläche zumindest abschnittsweise chemisch metallisierbar ist.

13. Elektrischer Taster nach Anspruch 12, wobei die chemisch metallisierbare Oberfläche des ersten thermoplastischen Kunststoffs (T1), vorzugsweise durch Ätzen, aufgerauht und mit Metallkeimen belegt ist.

14. Elektrischer Taster nach Anspruch 12 oder 13, wobei das erste (1T) und/oder das zweite Kontaktelement (2T) zumindest abschnittsweise von einem zweiten, elektrisch isolierenden thermoplastischen Kunststoff (T2) umgeben sind und die Oberfläche des zweiten thermoplastischen Kunststoffs (T2) nicht chemisch metallisiebar ist.

15. Elektrischer Taster nach einem der vorhergehenden Ansprüche 12 bis 14, wobei die zumindest abschnittsweise metallisierbare Oberfläche des ersten thermoplastischen Kunststoffs (T1) mit mindestens einer Metallschicht versehen ist und der erste thermoplastische Kunststoff (T1) aus der folgenden Gruppe ausgewählt ist: Acrylnitryl-Butadien-Styrol, Polyamid, Polycarbonat, Polystyrol.

16. Elektrischer Taster nach einem der vorhergehenden Ansprüche 12 bis 15, wobei das zweite Kontaktelement (2T) so geformt ist, daß es entgegen einer durch die elastischen Eigenschaften des ersten (T1) und zweiten thermoplastischen Kunststoffs (T2) gegebenen elastischen Rückstellkraft mit dem ersten Kontaktelement (1T) in Berührung bringbar ist.

17. Elektrischer Taster nach einem der vorhergehenden Ansprüche 12 bis 16, wobei das erste (1T) und/oder das zweite Kontaktelement (2T) einen konvex geformten Kontaktkörper (3T) aufweist und das erste (1T) und das zweite Kontaktelement (2T) einstückig ausgebildet sind.

18. Elektrischer Taster nach einem der vorhergehenden Ansprüche 12 bis 17, wobei das erste (1T) und das zweite Kontaktelement (2T) im Spritzgußverfahren hergestellt sind.

19. Elektrischer Taster nach einem der vorhergehenden Ansprüche 12 bis 18 als Bestandteil einer im Spritzgußverfahren hergestellten Baugruppe.

20. Elektrischer Taster nach einem der vorhergehenden Ansprüche 12 bis 19, wobei die Baugruppe und der elektrische Taster in einstückiger Ausbildung hergestellt sind.

21. Elektrischer Taster nach einem der vorhergehenden Ansprüche 12 bis 20, wobei das Spritzgußverfahren ein 2-Komponenten Spritzgußverfahren ist, wobei die eine Komponente der erste thermoplastische Kunststoff (T1) und die andere Komponente der zweite thermoplastische Kunststoff (T2) ist.

22. Elektrische Anschlußbuchse mit mindestens einem an einem Trägerstück (5A) aufgenommenen Kontaktstück (4A), **dadurch gekennzeichnet**, daß das Kontaktstück (4A, 6A) und das Trägerstück (5A) aus einem ersten thermoplastischen Kunststoff (T1) hergestellt sind, dessen Oberfläche zumindest abschnittsweise chemisch metallisierbar ist.

23. Elektrische Anschlußbuchse nach Anspruch 22, wobei die chemisch metallisierbare Oberfläche des ersten thermoplastischen Kunststoffs (T1), vorzugsweise durch Ätzen, aufgerauht und mit Metallkeimen belegt ist.

24. Elektrische Anschlußbuchse nach einem der vorhergehenden Ansprüche 22 oder 23, wobei das Kontaktstück (4A, 6A) und/oder das Trägerstück (5A) zumindest abschnittsweise mit einem zweiten, elektrisch isolierenden thermoplastischen Kunststoff (T2) beschichtet ist/sind und die Oberfläche des zweiten thermoplastischen Kunststoffs (T2) nicht chemisch metallisierbar ist.

25. Elektrische Anschlußbuchse nach einem der vorhergehenden Ansprüche 22 bis 24, wobei die zumindest abschnittsweise metallisierbare Oberfläche des ersten thermoplastischen Kunststoffs (T1) mit mindestens einer Metallschicht versehen ist und der erste thermoplastische Kunststoff (T1) aus der folgenden Gruppe ausgewählt ist: Acrylnitryl-Butadien-Styrol, Polyamid, Polycarbonat, Polystyrol.

26. Elektrische Abschlußbuchse nach einem der vorhergehenden Ansprüche 22 bis 25, wobei das Kontaktstück (4A, 6A) einen sich vom Trägerstück (5A) erstreckenden Rohrabschnitt (4A) aufweist.

27. Elektrische Anschlußbuchse nach einem der vorhergehenden Ansprüche 22 bis 26, wobei das Kontaktstück (4A, 6A) eine Mehrzahl von sich vom Trägerstück (5A) erstreckenden Vorsprüngen (6A) aufweist.

28. Elektrische Anschlußbuchse nach einem der vorhergehenden Ansprüche 22 bis 27, wobei das Trägerstück (5A) plattenartig ausgebildet ist und das Kontaktstück (4A, 6A) sich senkrecht von der Plattenober- und/oder - unterseite erstreckt und das Trägerstück (5A) und das Kontaktstück (4A, 6A) einstückig im Spritzgußverfahren hergestellt sind.

29. Elektrische Anschlußbuchse nach einem der vorhergehenden Ansprüche 22 bis 28, wobei die elektrische Anschlußbuchse (1A) eine Cinch-Buchse ist.

30. Elektrische Anschlußbuchse nach einem der vorhergehenden Ansprüche 22 bis 29 als Bestandteil einer im Spritzgußverfahren hergestellten Baugruppe.

31. Elektrische Anschlußbuchse nach einem der vorhergehenden Ansprüche 22 bis 30, wobei die Baugruppe und die elektrische Anschlußbuchse (1A) in einstückiger Ausbildung hergestellt sind.

32. Elektrische Anschlußbuchse nach einem der vorhergehenden Ansprüche 22 bis 31, wobei das Spritzgußverfahren ein 2-Komponenten Spritzgußverfahren ist, wobei die eine Komponente der erste thermoplastische Kunststoff (T1) und die andere Komponente der zweite thermoplastische Kunststoff (T2) ist.

33. Verfahren zur Metallisierung einer Kunststoffoberfläche mit folgenden Schritten:
a) zumindest abschnittsweises Aktivieren der Oberfläche mittels Koronabehandlung,
b) Belegen der aktivierten Oberfläche mit Metallkeimen und
c) Galvanisieren der Oberfläche.

34. Verfahren nach Anspruch 33, wobei beim Schritt lit. b
b1) die Oberfläche in ein erste Metallionen enthaltendes erstes Bad getaucht wird und anschließend
b2) die an der Oberfläche anhaftenden ersten Metallionen durch Tauchen in eine zweites ein Metallborhydid enthaltendes Bad reduziert werden.

35. Verfahren nach einem der vorhergehenden Ansprüche 33 oder 34, wobei nach dem Schritt lit. b die Oberfläche durch Tauchen in ein drittes Bad chemisch metallisiert wird und als erste Metallionen Palladium-, Gold-oder Silberionen verwendet werden.

36. Verfahren nach einem der vorhergehenden Ansprüche 33 bis 35 zur Herstellung eines elektrischen Bauelements im 2-Komponenten Spritzgußverfahren, bei dem die eine Komponente aus einem ersten thermoplastischen Kunststoff und die andere Komponente aus einem zweiten thermoplastischen Kunststoff gespritzt wird, und wobei die Oberfläche des ersten thermoplastischen Kunststoffs vor dem Spritzen des zweiten thermoplastischen Kunststoffs aktiviert wird.

37. Verfahren nach Anspruch 36, wobei der erste thermoplastische Kunststoff zumindest abschnittsweise mit dem zweiten thermoplastischen Kunststoff umspritzt wird und Oberfläche des zweiten thermoplastischen Kunststoffs nicht unmittelbar metallisierbar ist.

38. Verfahren nach einem der Ansprüche 36 bis 37, wobei der zweite thermoplastische Kunststoff elektrisch isolierend ist.

39. Verfahren nach einem der Ansprüche 36 bis 38, wobei der aus erstem und zweiten thermoplastischen Kunststoff hergestellte Formling chemisch metallisiert und anschließend galvanisiert wird und der erste und/oder zweite thermoplastische Kunststoff aus der folgenden Gruppe ausgewählt ist: Acrylnitryl-Butadien-Styrol, Polyamid, Polycarbonat, Polystyrol oder Polyethylen.
